# EUROPÄISCHE PATENTSCHRIFT

(11) **EP 1 639 626 B1**
(45) Veröffentlichungstag und Bekanntmachung des Hinweises auf die Patenterteilung: **15.12.2010**
(21) Anmeldenummer: 04740098.1
(22) Anmeldetag: 19.06.2004
(51) Int. Cl.: H01L 21/00, B65G 1/00

(54) **LAGERSYSTEM FÜR WAFER**
STORAGE SYSTEM FOR WAFERS
SYSTEME DE STOCKAGE DE PLAQUETTES DE SILICIUM

(30) Priorität: 02.07.2003 DE 10329868
(43) Veröffentlichungstag der Anmeldung: 29.03.2006
(73) Patentinhaber: Dynamic Microsystems Semiconductor Equipment GmbH, 78315 Radolfzell (DE)
(72) Erfinder: MORAN, Thomas, J., 78315 Radolfzell-Stahringen (DE)
(74) Vertreter: Duhme, Torsten
(86) Internationale Anmeldenummer: PCT/EP2004/006657
(87) Internationale Veröffentlichungsnummer: WO 2005/004209

(56) Entgegenhaltungen:
- EP-A- 1 197 990
- US-A- 5 961 323
- US-A1- 2002 094 257
- PATENT ABSTRACTS OF JAPAN Bd. 018, Nr. 661 (E-1644), 14. Dezember 1994 (1994-12-14) -& JP 06 260546 A (MITSUBISHI MATERIALS SHILICON CORP; others: 01), 16. September 1994 (1994-09-16)

## Beschreibung

Die Erfindung gemäß dem Anspruch 1 geht aus von einem Lagersystem für Wafer mit mindestens einem Lagermodul, in dem die Wafer säulenartig übereinander in Paketen gelagert sind, und mit einem neben dem Lagermodul befindlichen Ein- und Ausgabemodul, das einen Roboter enthält.

Ein Lagersystem der vorstehend genannten Art ist aus EP 1 197 990 A2 bekannt.

Beim Herstellen von Halbleitern ist es bekannt, so genannte Wafer zu verwenden. Hierunter versteht man kreisförmige flache Substrate von typischerweise 300 mm Durchmesser. Diese Wafer müssen im Laufe des Herstellungsprozesses mehrfach zwischen verschiedenen Bearbeitungsschritten zwischengelagert werden.

Es ist aus der bereits erwähnten EP 1 197 990 A2 bekannt, die Wafer übereinander in vertikalen, säulenartigen Paketen zu lagern. Hierzu können z.B. pfostenartige Gebilde verwendet werden, die mit seitlichen, schlitzförmigen Aufnahmen versehen sind. In diese Aufnahmen werden die einzelnen Wafer eingesteckt und auf diese Weise gelagert bzw. zwischengelagert. Alternativ ist auch bekannt, so genannte "Körbe" zu verwenden, in denen jeweils eine Gruppe von Wafern gehalten wird, wobei diese Körbe dann ebenfalls übereinander gestapelt werden.

Bei dem bekannten Lagersystem sind jeweils vier säulenartige Pakete auf einem Karussell angeordnet, das um eine vertikale Achse gedreht werden kann. Mit Hilfe des Karussells kann ein Paket mit Wafern in eine Übergabeposition gebracht werden, an der ein Greifwerkzeug einzelne Wafer aus dem Paket entnehmen kann bzw. in das Paket einsetzen kann.

Bei typischen bekannten Lagersystemen werden auf diese Weise z.B. 175 Wafer übereinander in einer derartigen Säule gelagert. Beim Einsetzen bzw. beim Entnehmen der Wafer werden diese, wie bereits erwähnt, entweder einzeln oder gruppenweise gehandhabt. Die einzelne Handhabung ist im Allgemeinen bevorzugt.

Aus US 2002/0094257 A1 ist ferner ein Lagersystem für sog. Reticel bekannt, das nach der Beschreibung auch zum Lagern von Wafern und Flachbildschirmen verwendet bzw. ausgebaut werden kann. Auch hier werden die zu lagernden Gegenstände auf Karussells gelagert, die um eine vertikale Achse drehbar sind. Im Unterschied zu dem vorher beschriebenen Lagersystem werden die zu lagernden Gegenstände hier allerdings auf den Karussells in einer vertikalen Lage einzeln gehalten.

Vor diesem Hintergrund ist es eine Aufgabe der Erfindung, ein Lagersystem der eingangs genannten Art dahingehend weiterzubilden, dass bei vergleichbarem Flächenbedarf eine größere Lagerkapazität zur Verfügung steht. Dabei sollen die Bewegungsvorgänge des Roboters möglichst einfach sein.

Diese Aufgabe wird durch ein Lagersystem der eingangs genannten Art gelöst, bei dem das Karussell einen inneren Drehteller und einen äußeren Drehteller aufweist, die unabhängig voneinander um eine vertikale Achse drehbar sind.

Dadurch, dass der Roboter nur noch eine einzige Position, nämlich die Übergabeposition, anfahren muss, werden zunächst die Bewegungsvorgänge vereinfacht. Darüber hinaus hat die Beweglichkeit der Pakete auf dem Karussell den Vorteil, dass auf die Bewegungsvorgänge des Roboters keine Rücksicht mehr genommen werden muss und die Pakete daher wesentlich dichter und nicht notwendigerweise einzeln für den Roboterarm zugänglich angeordnet werden müssen. Auf diese Weise kann die Packungsdichte der Pakete erhöht werden, so dass unter Beibehaltung eines einzigen Roboters mit dessen erforderlichem Flächenbedarf wesentlich mehr Pakete in dem selben Lagersystem eingesetzt werden können.

Die neue Realisierung, wonach das Karussell einen inneren Drehteller und einen äußeren Drehteller aufweist, die unabhängig voneinander um eine vertikale Achse drehbar sind, besitzt den Vorteil, dass die Packungsdichte der Pakete weiter erhöht werden kann, ohne dass dadurch die Zugänglichkeit behindert oder die Komplexität des Bewegungsvorganges erhöht wird.

Dies gilt insbesondere für eine Weiterbildung, bei der dem inneren Drehteller und dem äußeren Drehteller jeweils eine Übergabeposition zugeordnet ist, diese Übergabepositionen im Wesentlichen auf einer durch die vertikale Achse verlaufenden Radiallinie angeordnet sind, und dann, wenn der innere Drehteller zur Übergabe der vorbestimmten Wafer das vorbestimmte Paket in die Übergabeposition des inneren Drehtellers fährt, der äußere Drehteller mit einer Leerstelle auf seine Übergabeposition verfahrbar ist.

Diese Maßnahme hat den Vorteil, dass bei extrem einfachen Bewegungsabläufen ein optimaler Zugriff auf sämtliche Pakete des äußeren und des inneren Drehtellers möglich ist. Dies gilt insbesondere für das Verfahren des Armes in dessen Horizontalebene, weil dieser beim Anfahren der einen oder der anderen Übergabeposition lediglich geringfügig linear entlang der Radiallinie verfahren werden muss.

Wie bereits erwähnt wurde, können die Wafer bei derartigen Lagersystemen entweder einzeln oder gruppenweise übergeben werden, letzteres insbesondere in so genannten Körben.

Bei weiteren Ausführungsbeispielen der Erfindung ist bevorzugt, wenn neben dem Ein- und Ausgabemodul zwei im Wesentlichen baugleiche Lagermodule angeordnet sind, wobei der Roboter mit beiden Lagermodulen in Wirkverbindung steht.

Diese Maßnahme hat den Vorteil, dass eine weitere Erhöhung der Packungsdichte und damit eine weitere Verminderung des Platzbedarfes erreicht wird, wenn man dem Roboter nicht nur ein sondern zwei Lagermodule, möglicherweise auch drei oder mehr Lagermodule zuordnet, die sämtlich gemeinsam von dem einen Roboter bearbeitet werden. Dann ist der für den Roboter erforderliche Platzbedarf nur ein einziges Mal aufzuwenden, und die Kapazität des Lagersystems wird entsprechend erhöht.

Bei Ausführungsformen der Erfindung ist der Roboter mittels einer Vertikaleinheit verfahrbar. Dabei ist weiter bevorzugt, wenn der Arm ein Knickarm ist.

Diese Maßnahmen haben den Vorteil, dass alle Lagerstellen an den Übergabepositionen mit extrem einfachen Bewegungsabläufen des Roboters angefahren werden können. Dies führt zu einer Verminderung der Verfahrzeit und damit zu einer Verminderung der Zugriffszeit innerhalb des Lagersystems.

Im Rahmen der vorliegenden Erfindung ist ferner bevorzugt, wenn das Ein- und Ausgabemodul Mittel zum Erfassen und ggf. Korrigieren der Drehlage der Wafer und/oder Mittel zum Erfassen einer Markierung der Wafer aufweist.

Diese Maßnahmen haben den Vorteil, dass der Weg jedes einzelnen Wafers lückenlos dokumentiert werden kann. Dies bezieht sich insbesondere auf die genormten Markierungen (Bar-Codes), die am Rande der Wafer in definierter Nähe eines so genannten "notch", d.h. einer halbkreisförmigen Einkerbung am Waferumfang, angeordnet sind.

Die genannten Maßnahmen haben den Vorteil, dass zunächst die Lage des notch in einfacher Weise erkannt werden kann. Erweist sich dabei, dass der Wafer sich mit seinem notch nicht an der definierten Umfangsposition befindet, kann der Wafer zunächst entsprechend verdreht werden, beispielsweise mittels eines Drehtellers, bis sich der notch in der Solllage befindet. Dann kann die neben dem notch liegende Markierung ausgelesen und damit sichergestellt werden, dass die Ein- oder Ausgabe des Wafers in angemessener Form dokumentiert wird.

All dies geschieht vorzugsweise erfindungsgemäß im Bereich von Ein- und Ausgabestationen für die Wafer, die an dem Ein- und Ausgabemodul ebenfalls vorgesehen sind.

Bei einer weiteren Gruppe von Ausführungsbeispielen weist das Lagermodul ein Gehäuse auf, das mit Ausnahme einer zum Ein- und Ausgabemodul weisenden Öffnung geschlossen ist.

Diese Maßnahme hat den Vorteil, dass die gelagerten Wafer optimal gegen Kontamination geschützt werden können.

Zum Durchführen von Wartungsarbeiten und dergleichen kann erfindungsgemäß im Gehäuse ferner eine verschließbare Tür vorgesehen sein.

Damit die Wafer innerhalb des Lagermoduls kontaminationsfrei gelagert werden können, sind ferner am Lagermodul und/oder auch am Ein- und Ausgabemodul Laminarflow-Einheiten und/oder Elektrostatik-Entlade-Einheiten vorgesehen.

Diese Maßnahmen gewährleisten, dass die Wafer nur einer Reinraumatmosphäre ausgesetzt werden, die überdies frei von elektrostatischen Ladungen ist.

Weitere Vorteile ergeben sich aus der Beschreibung und der beigefügten Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ein Ausführungsbeispiel der Erfindung ist in der Zeichnung dargestellt und wird in der nachfolgenden Beschreibung näher erläutert. Es zeigen:
- Fig. 1: ein Ausführungsbeispiel eines erfindungsgemäßen La- gersystems in einer seitlichen Schnittansicht entlang der Linie I-I von Fig. 2;
- Fig. 2: eine Draufsicht auf das Lagersystem gemäß Fig. 1, ebenfalls im Schnitt und entlang einer Linie II-II von Fig. 1.

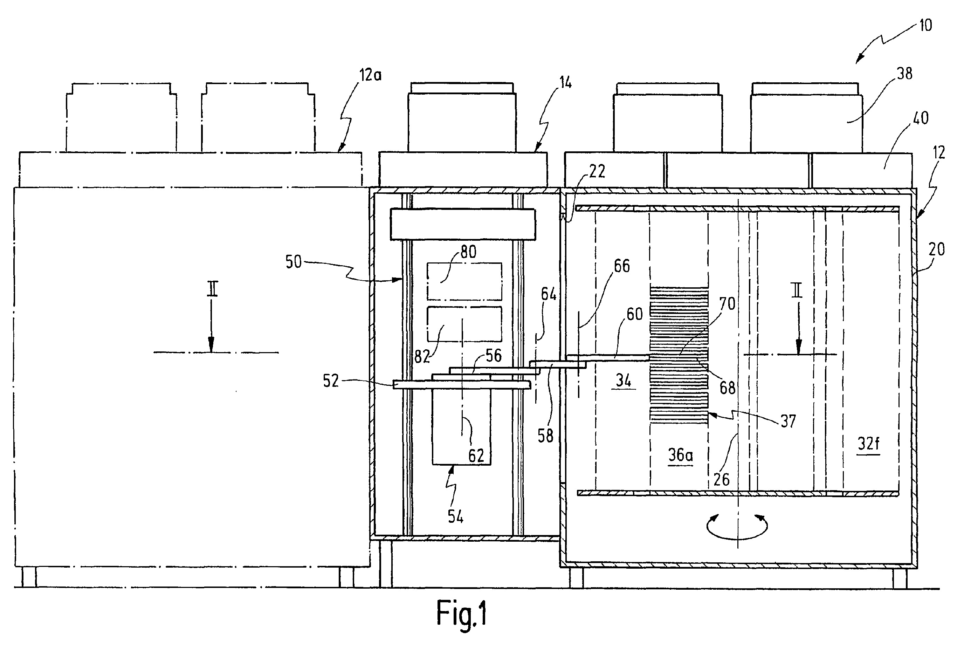

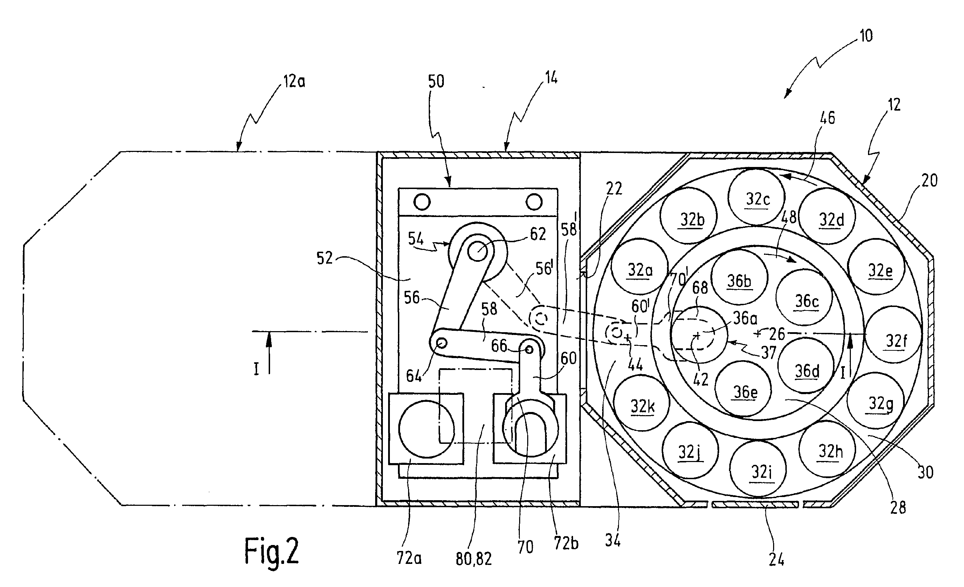

In Fig. 1 und 2 bezeichnet 10 insgesamt ein Lagersystem für Wafer. Das Lagersystem 10 weist ein Lagermodul 12 auf, das seitlich mit einem Ein- und Ausgabemodul 14 verbunden ist. Bei Ausführungsbeispielen der Erfindung können auch zwei Lagermodule 12, 12a zu beiden Seiten des Ein- und Ausgabemoduls 14 angeordnet sein, wie mit strichpunktierten Linien für ein weiteres Lagermodul 12a angedeutet. Darüber hinaus sind auch Anordnungen mit drei oder mehr derartigen Lagermodulen denkbar.

Das Lagermodul 12 ist mit einem geschlossenen Gehäuse 20 versehen, das lediglich im Übergang zum Ein- und Ausgabemodul 14 eine Öffnung 22 als Durchreiche aufweist. Ferner kann im Gehäuse 20 eine Tür 24 vorgesehen sein, insbesondere für Wartungs- und Reparaturzwecke.

Innerhalb des Lagermoduls 12 befindet sich ein Förderer, der als ein um eine Vertikalachse 26 drehbares Karussell ausgebildet ist. Das Karussell besteht aus einem inneren Drehteller 28 und einem äußeren Drehteller 30. Wie man aus Fig. 2 deutlich erkennen kann, sind auf dem äußeren Drehteller 30 insgesamt elf Positionen 32a bis 32k sowie eine Leerposition 34 vorgesehen. Der innere Drehteller 28 verfügt hingegen über fünf Positionen 36a bis 36e. Mit 37 ist in Fig. 1 ein Paket von übereinander gestapelten Wafern angedeutet. Geht man also wiederum von einer Kapazität von 175 Wafern je säulenartigem Paket 37 aus, so hätte das Lagermodul 12 mit insgesamt sechzehn Positionen 32, 36 eine Kapazität von insgesamt 2.800 Wafern.

Auf dem Gehäuse 20 sind Laminarflow-Einheiten 38 sowie Elektrostatik-Entlade-Einheiten 40 vorgesehen. Mit diesen Einheiten ist es möglich, im Inneren des Gehäuses 20 Reinraumbedingungen herzustellen und zu gewährleisten, wobei die im Gehäuse 20 befindliche Luft auch weitestgehend frei von elektrostatischen Ladungen ist.

Zur Übergabe von Wafern in das Lagermodul 12 bzw. aus dem Lagermodul 12 sind im Lagermodul 12 zwei raumfeste Übergabepositionen definiert, nämlich eine innere Übergabeposition 42 im Bereich des inneren Drehtellers 28 sowie eine äußere Übergabeposition 44 im Bereich des äußeren Drehtellers 30. Die Übergabepositionen 42, 44 befinden sich auf einer gemeinsamen Radiallinie, die die vertikale Achse 26 schneidet und im Wesentlichen mittig durch die Öffnung 22 verläuft.

In Fig. 2 ist mit Pfeilen 46 und 48 noch angedeutet, dass der innere Drehteller 28 und der äußere Drehteller 30 unabhängig voneinander und auch mit unterschiedlichem Drehsinn angetrieben werden können. Hierzu sind entsprechende Antriebe vorgesehen, die der Übersichtlichkeit halber in der Figur nicht gezeigt sind. Dies gilt auch für die zugehörige Steuerung, die für den Fachmann offensichtlich ist.

Innerhalb des Ein- und Ausgabemoduls 14 befindet sich eine Vertikaleinheit 50 mit einem auf vertikalen Säulen laufenden Schlitten 52. Der Schlitten 52 trägt einen Roboter 54. Der Roboter 54 weist einen Knickarm mit einem ersten Teilarm 56, einem zweiten Teilarm 58 und einem dritten Teilarm 60 auf. Der Roboter 54 und die Teilarme 56, 58, 60 sind miteinander über Drehachsen 62, 64 und 66 verbunden. Auch hier gilt, dass die Antriebe und die Steuerung des Roboters 54 der Übersichtlichkeit halber nicht dargestellt sind und dass der Fachmann derartige Antriebe und Steuerungen kennt.

In Fig. 1 ist dargestellt, wie der Roboter 54 mit den Teilarmen 56, 58, 60 einen Wafer 68 aus dem Paket 37 entnimmt. Zu diesem Zweck ist der dritte Teilarm 60 an seinem freien Ende mit einer Hand 70 versehen. Dieser Vorgang ist in Fig. 2 gestrichelt dargestellt.

Damit der Knickarm mit den Teilarmen 56, 58, 60 auf die Positionen 36a bis 36e des inneren Drehtellers 28 zugreifen kann, ist es erforderlich, dass der äußere Drehteller 30 zunächst in eine Position gefahren wird, in der sich die Leerposition 34 des äußeren Drehtellers 30 auf der äußeren Übergabeposition 44 befindet.

In Fig. 2 ist durchgezogen dargestellt, wie der Knickarm mit den Teilarmen 56, 58, 60 einen Wafer auf die in Fig. 2 rechte Ein- und Ausgabestationen 72 überführt.

Bevor dies geschieht, kann eine Kontrolle bzw. Dokumentierung der Wafer vorgenommen werden.

Hierzu dienen ein Code-Leser 80 sowie ein so genannter "notch-finder" 82. Der notch-finder 82 kann beispielsweise eine Digitalkamera sein.

Diese beiden letztgenannten Einheiten machen sich die Tatsache zu Nutze, dass Wafer üblicherweise an einer definierten Umfangsposition mit einer halbkreisförmigen Ausnehmung, dem so genannten "notch", versehen sind. In definierter Lage relativ zu dem notch befindet sich auf einer Oberfläche des Wafers eine Markierung, beispielsweise ein Bar-Code. Diese Markierung identifiziert den jeweiligen Wafer und gibt darüber hinaus an, welche Bearbeitungsstationen er bereits durchlaufen hat. Ferner dient der Bar-Code dazu, anzugeben, in welcher Ausrichtung sich die Kristallisierung des Wafers relativ zum notch befindet.

Wenn nun ein Wafer z.B. aus dem Lagermodul 12 entnommen wird, kann zunächst der Roboter 54 mit dem Wafer so verfahren werden, dass zunächst im notch-finder 82 erkannt wird, ob sich der notch an der korrekten Position befindet. Wenn dies der Fall ist, wird der Wafer sogleich weiter zum Code-Leser 80 gefahren. Dort wird die Markierung ausgelesen und der Wafer entsprechend dokumentiert.

Stellt der notch-finder 82 hingegen fest, dass sich der notch nicht an der erwarteten Position befindet, verfährt der Roboter 54 den Wafer zu einem (in der Fig. nicht dargestellten) Drehteller, auf dem der Wafer so verdreht wird, dass sich nunmehr der notch an der richtigen Position befindet. Dies kann entweder im notch-finder 82 noch einmal überprüft werden, oder der Wafer wird dann unmittelbar dem Code-Leser 80 zugeführt.

Wie bereits mehrfach erwähnt wurde, kann das erfindungsgemäße Lagersystem 10 entweder nach dem Prinzip arbeiten, dass die Wafer einzeln gehandhabt werden, während alternativ auch eine Handhabung in Körben, d.h. mit Gruppen von Wafern, möglich ist. Dies wirkt sich naturgemäß auch auf die Art der Ein- und Ausgabestationen 72a, 72b an dem Ein- und Ausgabemodul 14 aus.

## Patentansprüche

1. Lagersystem für Wafer (68) mit mindestens einem Lagermodul (12, 12a), in dem die Wafer (68) säulenartig übereinander in Paketen (37) gelagert sind, und mit einem neben dem Lagermodul (12, 12a) befindlichen Ein- und Ausgabemodul (14), das einen Roboter (54) enthält, wobei der Roboter (54) einen Arm (56, 58, 60) aufweist, der im Wesentlichen in einer Horizontalebene bewegbar ist und mit dem vorbestimmte Wafer (68) seitlich aus einem vorbestimmten Paket (37) entnehmbar bzw. in dieses einsetzbar sind, wobei die Pakete (37) in dem Lagermodul (12, 12a) auf einem im Wesentlichen in einer Horizontalebene laufenden Karussell (28, 30) angeordnet sind und wobei das vorbestimmte Paket (37) mit dem Karussell (28, 30) in eine Übergabeposition (42, 44) bringbar ist, an der die vorbestimmten Wafer (68) zwischen dem Arm (56, 58, 60) und dem vorbestimmten Paket (37) übergebbar sind, **dadurch gekennzeichnet, dass** das Karussell einen inneren Drehteller (28) sowie einen äußeren Drehteller (30) aufweist, die unabhängig voneinander (46, 48) um eine vertikale Achse (26) drehbar sind.

2. Lagersystem nach Anspruch 1, **dadurch gekennzeichnet, dass** dem inneren Drehteller (28) und dem äußeren Drehteller (30) jeweils eine Übergabeposition (42, 44) zugeordnet ist, dass diese Übergabepositionen (42, 44) im Wesentlichen auf einer durch die vertikale Achse (26) verlaufenden Radiallinie angeordnet sind, und dass dann, wenn der innere Drehteller (28) zur Übergabe der vorbestimmten Wafer (68) das vorbestimmte Paket (37) in die Übergabeposition (42) des inneren Drehtellers (28) fährt, der äußere Drehteller (30) mit einer Leerstelle (34) auf seine Übergabeposition (44) verfahrbar ist.

3. Lagersystem nach Anspruch 1 oder 2, **dadurch gekennzeichnet, dass** die Wafer (68) einzeln übergebbar sind.

4. Lagersystem nach einem oder mehreren der Ansprüche 1 bis 3, **dadurch gekennzeichnet, dass** die Wafer gruppenweise übergebbar sind, vorzugsweise in Körben.

5. Lagersystem nach einem oder mehreren der Ansprüche 1 bis 4, **dadurch gekennzeichnet, dass** neben dem Ein- und Ausgabemodul (14) zwei im Wesentlichen baugleiche Lagermodule (12, 12a) angeordnet sind, und dass der Roboter (54) mit beiden Lagermodulen (12, 12a) in Wirkverbindung steht.

6. Lagersystem nach einem oder mehreren der Ansprüche 1 bis 5, **dadurch gekennzeichnet, dass** der Roboter (54) mittels einer Vertikaleinheit (50) verfahrbar ist.

7. Lagersystem nach einem oder mehreren der Ansprüche 1 bis 6, **dadurch gekennzeichnet, dass** der Arm (56, 57, 58) ein Knickarm ist.

8. Lagersystem nach einem oder mehreren der Ansprüche 1 bis 7, **dadurch gekennzeichnet, dass** das Ein- und Ausgabemodul (14) Mittel (82) zum Erfassen und ggf. Korrigieren der Drehlage der Wafer (68) aufweist.

9. Lagersystem nach einem oder mehreren der Ansprüche 1 bis 8, **dadurch gekennzeichnet, dass** das Ein- und Ausgabemodul (14) Mittel (80) zum Erfassen einer Markierung der Wafer (68) aufweist.

10. Lagersystem nach einem oder mehreren der Ansprüche 1 bis 9, **dadurch gekennzeichnet, dass** das Ein- und Ausgabemodul (14) Ein- und Ausgabestationen (72a, 72b) für die Wafer (68) aufweist.

11. Lagersystem nach einem oder mehreren der Ansprüche 1 bis 10, **dadurch gekennzeichnet, dass** das Lagermodul (12, 12a) ein Gehäuse (20) aufweist, das mit Ausnahme einer zum Ein- und Ausgabemodul (14) weisenden Öffnung (22) geschlossen ist.

12. Lagersystem nach Anspruch 11, **dadurch gekennzeichnet, dass** das Gehäuse (20) ferner eine verschließbare Tür (24) aufweist.

13. Lagersystem nach einem oder mehreren der Ansprüche 1 bis 12, **dadurch gekennzeichnet, dass** das Lagermodul (12, 12a) und/oder das Ein- und Ausgabemodul (14) mit einer Laminarflow-Einheit (38) versehen sind.

14. Lagersystem nach einem oder mehreren der Ansprüche 1 bis 13, **dadurch gekennzeichnet, dass** das Lagermodul (12, 12a) und/oder das Ein- und Ausgabemodul (14) mit einer Elektrostatik-Entlade-Einheit (40) versehen sind.

## Claims

1. A storage system for wafers (68) comprising at least one storage module (12, 12a), in which the wafers (68) are stored one on top of the other in packets (37) similar to a column, and comprising an inserting and dispensing module (14), which is located next to the storage module (12, 12a) and which comprises a robot (54), the robot (54) having an arm (56, 58, 60) which is movable substantially in a horizontal plane and with which predetermined wafers (68) can be laterally removed from or inserted into a predetermined packet (37), wherein the packets (37) are arranged in the storage module (12, 12a) on a carousel (28, 30) that runs substantially in a horizontal plane, and wherein the predetermined packet (37) can be brought by the carousel (28, 30) into a transfer position (42, 44), at which the predetermined wafers (68) can be transferred between the arm (56, 58, 60) and the predetermined packet (37), **characterized in that** the carousel has an inner turntable (28) and an outer turntable (30), which are rotatable independently of each other (46, 48) about a vertical axis (26).

2. The storage system of claim 1, **characterized in that** the inner turntable (28) and the outer turntable (30) each are provided with a transfer position (42, 44), wherein these transfer positions (42, 44) are arranged substantially on a radial line that runs through the vertical axis (26), and wherein the outer turntable (30) is capable of moving to its transfer position (44) with an empty location (34), whenever the inner turntable (28) moves the predetermined packet (37) into the transfer position (42) of the inner turntable (28) for transferring the predetermined wafers (68).

3. The storage system of claim 1 or 2, **characterized in that** the wafers (68) can be transferred individually.

4. The storage system of one or more of claims 1 to 3, **characterized in that** the wafers can be transferred in groups, preferably in baskets.

5. The storage system of one or more of claims 1 to 4, **characterized in that** two substantially identical storage modules (12, 12a) are arranged next to the inserting and dispensing module (14), wherein the robot (54) is in operative connection with both storage modules (12, 12a).

6. The storage system of one or more of claims 1 to 5, **characterized in that** the robot (54) can be made to move by means of a vertical unit (50).

7. The storage system of one or more of claims 1 to 6, **characterized in that** the arm (56, 57, 58) is a bending arm.

8. The storage system of one or more of claims 1 to 7, **characterized in that** the inserting and dispensing module (14) comprises means (82) for sensing and, if applicable, correcting the rotational position of the wafers (68).

9. The storage system of one or more of claims 1 to 8, **characterized in that** the inserting and dispensing module (14) comprises means (80) for sensing a marking of the wafers (68).

10. The storage system of one or more of claims 1 to 9, **characterized in that** the inserting and dispensing module (14) comprises inserting and dispensing stations (72a, 72b) for the wafers (68).

11. The storage system of one or more of claims 1 to 10, **characterized in that** the storage module (12, 12a) comprises a housing (20) which is closed with the exception of an opening (22) facing the inserting and dispensing module (14).

12. The storage system of claim 11, **characterized in that** the housing (20) also has a closable door (24).

13. The storage system of one or more of claims 1 to 12, **characterized in that** the storage module (12, 12a) and/or the inserting and dispensing module (14) are provided with a laminar flow unit (38).

14. The storage system of one or more of claims 1 to 13, **characterized in that** the storage module (12, 12a) and/or the inserting and dispensing module (14) are provided with an electrostatic discharge unit (40).

## Revendications

1. Système de stockage de plaquettes de silicium (68) avec au moins un module de stockage (12, 12a), dans lequel les plaquettes de silicium (68) sont stockées en paquets (37) superposés en colonne, et avec un module d'entrée et de sortie (14) se trouvant à côté du module de stockage (12, 12a) et comportant un robot (54), dans lequel le robot (54) présente un bras (56, 58, 60) qui est mobile essentiellement dans un plan horizontal et qui peut être extrait latéralement d'un paquet prédéterminé (37) ou introduit dans celui-ci avec la plaquette de silicium prédéterminée (68), dans lequel les paquets (37) sont disposés dans le module de stockage (12, 12a) sur un carrousel (28, 30) tournant essentiellement dans un plan horizontal et dans lequel le paquet prédéterminé (37) peut être amené avec le carrousel (28, 30) dans une position de transfert (42, 44), dans laquelle les plaquettes de silicium prédéterminées (68) peuvent être transférées entre le bras (56, 58, 60) et le paquet prédéterminé (37), **caractérisé en ce que** le carrousel présente un plateau tournant intérieur (28) ainsi qu'un plateau tournant extérieur (30), qui peuvent tourner autour d'un axe vertical (26) indépendamment l'un de l'autre (46, 48).

2. Système de stockage selon la revendication 1, **caractérisée en ce qu'**une position de transfert (42, 44) est associée respectivement au plateau tournant intérieur (28) et au plateau tournant extérieur (30), **en ce que** ces positions de transfert (42, 44) sont disposées essentiellement sur une ligne radiale passant par l'axe vertical (26), **en ce que**, lorsque le plateau tournant intérieur (28) déplace le paquet prédéterminé (37) dans la position de transfert (42) du plateau tournant intérieur (28) pour le transfert de la plaquette de silicium prédéterminée (68), le plateau tournant extérieur (30) peut être amené avec une zone vide (34) dans sa position de transfert (44).

3. Système de stockage selon la revendication 1 ou 2, **caractérisé en ce que** les plaquettes de silicium prédéterminées (68) peuvent être transférées individuellement.

4. Système de stockage selon une ou plusieurs des revendications 1 à 3, **caractérisé en ce que** les plaquettes de silicium peuvent être transférées par groupes, de préférence dans des paniers.

5. Système de stockage selon une ou plusieurs des revendications 1 à 4, **caractérisé en ce que** deux modules de stockage (12, 12a) de construction essentiellement identique sont disposés à côté du module d'entrée et de sortie (14), et **en ce que** le robot (54) est en liaison active avec les deux modules de stockage (12, 12a).

6. Système de stockage selon une ou plusieurs des revendications 1 à 5, **caractérisé en ce que** le robot (54) est déplaçable au moyen d'une, unité verticale (50).

7. Système de stockage selon une ou plusieurs des revendications 1 à 6, **caractérisé en ce que** le bras (56, 57, 58) est un bras coudé.

8. Système de stockage selon une ou plusieurs des revendications 1 à 7, **caractérisé en ce que** le module d'entrée et de sortie (14) présente des moyens (82) pour détecter et éventuellement pour corriger la position angulaire des plaquettes de silicium (68).

9. Système de stockage selon une ou plusieurs des revendications 1 à 8, **caractérisé en ce que** le module d'entrée et de sortie (14) présente des moyens (80) pour détecter un marquage des plaquettes de silicium (68).

10. Système de stockage selon une ou plusieurs des revendications 1 à 9, **caractérisé en ce que** le module d'entrée et de sortie (14) présente des stations d'entrée et de sortie (72a, 72b) pour les plaquettes de silicium (68).

11. Système de stockage selon une ou plusieurs des revendications 1 à 10, **caractérisé en ce que** le module de stockage (12, 12a) présente une enceinte (20) qui est fermée à l'exception d'une ouverture (22) tournée vers le module d'entrée et de sortie (14).

12. Système de stockage selon la revendication 11, **caractérisé en ce que** l'enceinte (20) présente en outre une porte (24) pouvant être fermée.

13. Système de stockage selon une ou plusieurs des revendications 1 à 12, **caractérisé en ce que** le module de stockage (12, 12a) et/ou le module d'entrée et de sortie (14) sont pourvus d'une unité à écoulement laminaire (38).

14. Système de stockage selon une ou plusieurs des revendications 1 à 13, **caractérisé en ce que** le module de stockage (12, 12a) et/ou le module d'entrée et de sortie (14) sont munis d'une unité à décharge électrostatique (40).
